# EUROPEAN PATENT SPECIFICATION

(11) **EP 0 402 556 B1**
(45) Date of publication and mention of the grant of the patent: **06.10.1993**
(21) Application number: 89810463.3
(22) Date of filing: 16.06.1989
(51) Int. Cl.: H01S 3/025, H01S 3/085, H01S 3/19, G02B 6/12

(54) **A method for improving the flatness of etched mirror facets**
Methode zur Verbesserung der Ebenheit geätzter Spiegelfacetten
Méthode pour améliorer la planéité des facettes de miroir gravées

(43) Date of publication of application: 19.12.1990
(73) Proprietor: International Business Machines Corporation, Armonk, N.Y. 10504 (US)
(72) Inventor: Buchmann, Peter Leo, Dr., CH-8135 Langnau am Albis (CH); Vettiger, Peter, CH-8135 Langnau am Albis (CH); Voegeli, Otto, Dr., CH-8803 Rüschlikon (CH); Webb, David John, Dr., CH-8803 Rüschlikon (CH)
(74) Representative: Barth, Carl Otto

(56) References cited:
- EP-A- 0 095 826
- I.E.E.E. JOURNAL OF QUANTUM ELECTRONICS, vol. QE-23, no. 8, August 1987, pages 1283-1286; J. CHEN, S. LEE: "AlGaAs/GaAs visible ridge waveguide laser with multicavity structure"
- IEEE JOURNAL OF QUANTUM ELECTRONICS, vol. QE-23, no. 3, March 1987, pages 309-312; L.D. ZHU et al.: "Low threshold ridge waveguide single quantum well laser processed by chemically assisted ion beam etching"
- Electronics Letters, vol. 23, No. 16 July 1987, pp 855-857

## Description

### TECHNICAL FIELD

The invention concerns a method for improving the flatness of etched mirror facets of integrated optic structures with non-planar stripe waveguides. Examples of structures that can be produced with the method are devices with active waveguides such as ridge diode lasers or groove diode lasers, passive waveguides, and also integrated optic modulators and switches.

### BACKGROUND OF THE INVENTION

Integrated optic devices with non-planar stripe waveguide structure, normally in semiconductor technology, have found applications in a wide variety of information handling systems because of their compact size and because their technology is compatible with that of the associated electronic circuitry.

One of the most important stripe waveguide structures in use today is the semiconductor diode laser that is particularly well suited for applications in data communication, optical memory and laser printing systems. In order to further improve the performance, strong efforts are being made to increase the scale of integration of opto-electronic integrated circuits. This requires the replacement of at least one cleaved mirror facet of the diode laser by an etched mirror. If good quality etched mirrors can be produced, this not only permits the integration of monitor diodes and electronic circuits but also allows to perform processes like mirror coating and testing on the wafer level. This with the benefit of reduced handling, increased yield and decreased fabrication and testing costs.

In addition to these improvements in integration and fabrication, etched mirrors make it possible to realize very short cavity lasers, groove-coupled cavity lasers, beam deflectors and surface emitters. Also, new types of laser and waveguide structures with curved and angled mirror facets can be fabricated using etching techniques.

One laser structure which has been found to be a good choice for high performance applications is the so-called ridge GRINSCH (Graded-Index Separate Confinement Heterostructure) laser diode which has been described, e.g., in an article "High-Power Ridge-Waveguide AlGaAs GRINSCH Laser Diode" by Ch. Harder et al. (Electr. Lett., Vol. 22, No. 22, September 25, 1986, pp. 1081-1082). It provides high quality beams at extremely low power dissipation and is very efficient and, therefore, has the potential for high reliability which is of utmost importance particularly for high-speed optical interconnections. The ridge waveguide, which can be fabricated using simple, established processes, stabilizes the transverse mode effectively. GRINSCH laser diode structures with extremely low threshold currents and current densities have been reported.

Major requirements for an etching process for laser mirrors are high etch rates (4 - 6 µm etch depth), low etch rate selectivity for various materials of the laser structure, vertical smooth facets with low damage, and a surface roughness of less than λ/10.

The best method so far known for the fabrication of vertical etched mirror facets in III-V compound (e.g. AlGaAs/GaAs) laser structures with layers of varying Al concentrations is chemically assisted ion beam etching (CAIBE). Such processes have been published
- in a paper "Chemically Assisted Ion Beam Etching Process for High Quality Laser Mirrors" by P. Buchmann et al. (given at the Int. Conf. on Microlithography, Vienna, September 1988), and
- in an article "High-Power Etched-Facet Laser" by P. Tihanyi et al. (Electr. Lett., Vol. 23, No. 15, July 16, 1987, pp. 772-773).

There is, however, an additional requirement which is especially important for single-mode lasers used for optical storage and for single-mode fiber communications. This is the flatness of the mirror facet. Any curvature of the mirror surface in the light mode region causes a phase shift distortion in both, the reflected and the transmitted light. Reflected light with a strong phase front distortion has a low coupling factor to the back-travelling waveguide mode. In other words, the effective reflectivity of a curved mirror of a single-mode waveguide is reduced and the threshold current increases. Such phase distortions also show up in the far-field of the laser output beam (side-lobes, multi-lobes). A non-Gaussian beam shape of the far-field means that the beam cannot be focussed to the ideal diffraction-limited spot using simple optics, resulting in a reduction of the possible storage density on, for example, a magneto-optic disk.

Flatness of the mirror facet has been found to be very difficult to achieve when the laser structure has a pronounced topography as is the case for ridge waveguide and some channeled substrate lasers, i.e., where non-planar waveguide structures are used. There are two main effects causing the curvature of the mirror:
1. Topography/Lithography: Applying the etch mask layer causes some planarization, i.e., for a ridge laser the mask is thinner on top of the ridge than on the etched horizontal surfaces on both sides of it. During mask fabrication, this causes, at the position of the ridge, an inward recess of the mask edge. This recess is transferred into the mirror facet by the anisotropic etching process. Although this recess is only between a few tens of nm and 500 nm, it is detrimental to the laser light wavefront since λ/2 in a GaAs laser correspond to only 110 nm. In experiments, large wafer-to-wafer variations in the curvature of the mirror facets were observed. The main distortion occurs underneath the edges of the ridge.
2. Mirror etching process: The process used for the formation of the mirror facets (such as CAIBE) can also introduce a curvature of the surface depending on the anisotropy and the undercutting in the etching process. If chemically reactive gases are introduced into the etching system, the local concentration of the active species can vary as a consequence of the topography, resulting in additional curvature of the etched facets.

The curvature problem has been recognized before and has been reported by N. Bouadma et al., in their article "GaAs/AlGaAs Ridge Waveguide Laser Monolithically Integrated with a Photodiode Using Ion Beam Etching" (Electr. Lett., Vol. 23, No. 16, July 1987, pp. 855-857). The authors describe an attempt that has been made to solve the problem by shortening the ridge for a few microns in the mirror facet region. With this approach, topographic effects can be avoided but at the expense of wavefront and far field distortions which occur because the waveguide provided by the ridge is drastically affected.

It is a main object of the present invention to provide a method for improving the flatness of etched mirror facets of integrated optic structures with non-planar stripe waveguides.

It is another object of the invention to provide a method for etching semiconductor diode laser mirrors of same or at least similar quality than that of mirrors obtained by using conventional high-quality cleaving techniques.

Still another object is to provide a method for etching diode laser mirrors with extremely flat, smooth and vertical surfaces using simple, easy-to-control process steps.

A further object is to provide a diode laser structure having at least one etched mirror which is of the same or at least similar quality than that of mirrors obtained by using a conventional high-quality cleaving technique.

### SUMMARY OF THE INVENTION

The invention as claimed is intended to meet these objectives and to remedy the drawbacks and deficiencies of known mirror etch techniques. The inventive method solves the problems hitherto encountered due to curvature of the mirror facets by using a waveguide that is widened at its end sections near the etched mirror facets. With this simple change, the curved facet regions are shifted away from the light mode region to a surface region where curvature is not critical.

The main advantage offered by the invention is that the problems due to topographic and lithographic effects on the etched mirror surface are avoided, which is an important achievement e.g. for ridge waveguide and channeled substrate lasers. The resulting mirror facets, flat in the light mode region, significantly improve the reflectivity and absorption coefficient of the etched mirrors as well as the far-field characteristics of single-mode etched mirror lasers. The coupling loss due to the non-guiding widened ridge section is, on the other hand, negligible.

### DESCRIPTION OF THE DRAWINGS

The invention is described in detail below with reference to drawings which illustrate a specific embodiment of the invention, and in which
- **Fig. 1**: is a perspective view of a ridge single quantum well (SQW) GRINSCH laser with a straight ridge resulting in curvature in the light mode region (PRIOR ART);
- **Fig. 2**: is a perspective view of a ridge single quantum well (SQW) GRINSCH laser with a widened-end ridge in accordance with the present invention, eliminating the curvature in the light mode region;
- **Fig. 3A - 3G**: are illustrations of the steps of the inventive mirror etching method applied to fabricate a SQW GRINSCH laser with widened ridge end sections.

### DETAILED DESCRIPTION

Before describing the invention in greater detail, the general concept will be outlined by comparing the conventionally used method with the inventive method, using a ridge AlGaAs/GaAs SQW GRINSCH structure with etched mirrors as an example for the application of the invention.

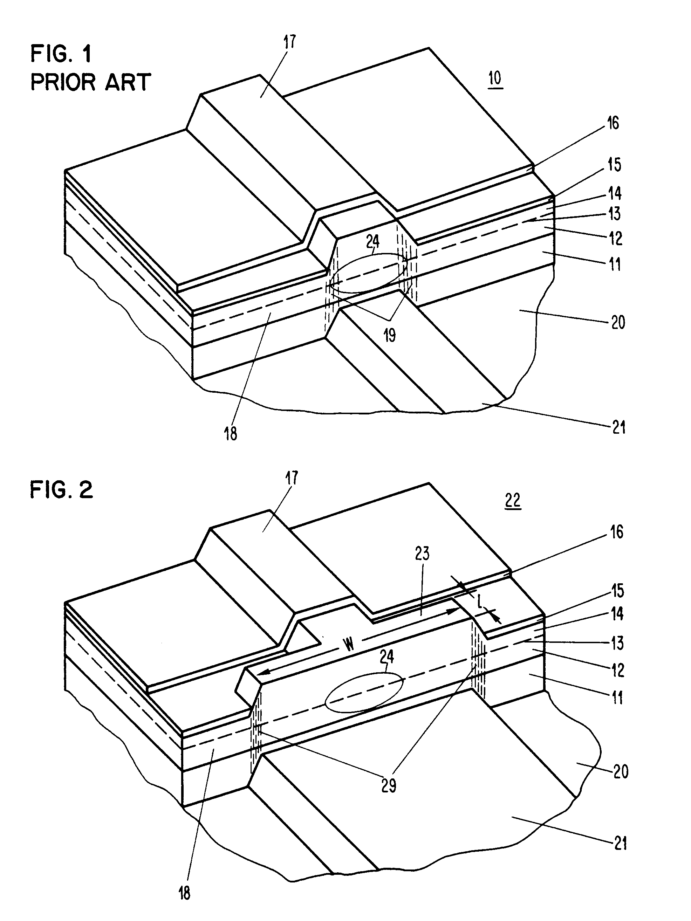

Fig. 1 schematically illustrates the main elements of a conventional ridge GRINSCH laser structure 10. The drawing shows the structure after completion of the mirror facet etching process. Deposited on a GaAs substrate 11 are: the lower AlGaAs cladding layer 12, the active GaAs layer 13 forming the quantum well, and the upper AlGaAs cladding layer 14. The latter has been etched to form ridge 17. The etched surfaces on both sides of the ridge are covered with an insulation layer 15. A metallization film 16, deposited on top of the layered laser structure for use as an electric contact, is schematically indicated. The vertical wall 18 of an etched mirror groove provides the mirror facet. The bottom 20 of the groove shows the same profile as the top surface of the initial laser structure, the "transferred" ridge being designated 21.

In Fig. 1, the light mode region is shown as an ellipse 24 centering around the active layer 13 and laterally defined by the stripe ridge 17. In the figure, the shaded areas 19 illustrate the bent regions of substantial curvature in the facet surface. These bent or curved regions cause the detrimental laser beam wavefront distortion which the present invention is to avoid.

Fig. 2 is a schematic illustration of a ridge SQW GRINSCH structure 22 fabricated in accordance with the principles of the invention. Those elements that are common to the structures of figures 1 and 2, carry the same reference numbers in both figures.

In the structure shown in Fig. 2, the ridge 17 is widened at its end near the mirror facet, forming the broad, or flared, section 23. Its width w is wider than the lateral extension of the light mode region 24. Thus, the bent facet regions which are formed under the ridge edges (19 in Fig. 1) are shifted away from the light mode region 24 to regions 29 where the facet curvature is not critical. The achieved result: In the light mode region, the mirror surface is completely flat since it is not affected by the curvature in areas 29.

In order to effectively eliminate any curvature in the critical light mode region 24, the widened waveguide section 23 needs to be substantially wider than the lateral extension of the full-width-at-half-maximum (FWHM) of the intensity distribution of the emitted laser beam.

The length of the laterally non-guiding widened ridge section 23 has to be as short as possible in order to minimize coupling loss of the divergent beam to the back-travelling waveguide mode. A length 1 of 2 µm is enough to avoid any topography effects within the light mode region 24 and is, at the same time, short enough to keep the mode coupling loss sufficiently low to be negligible.

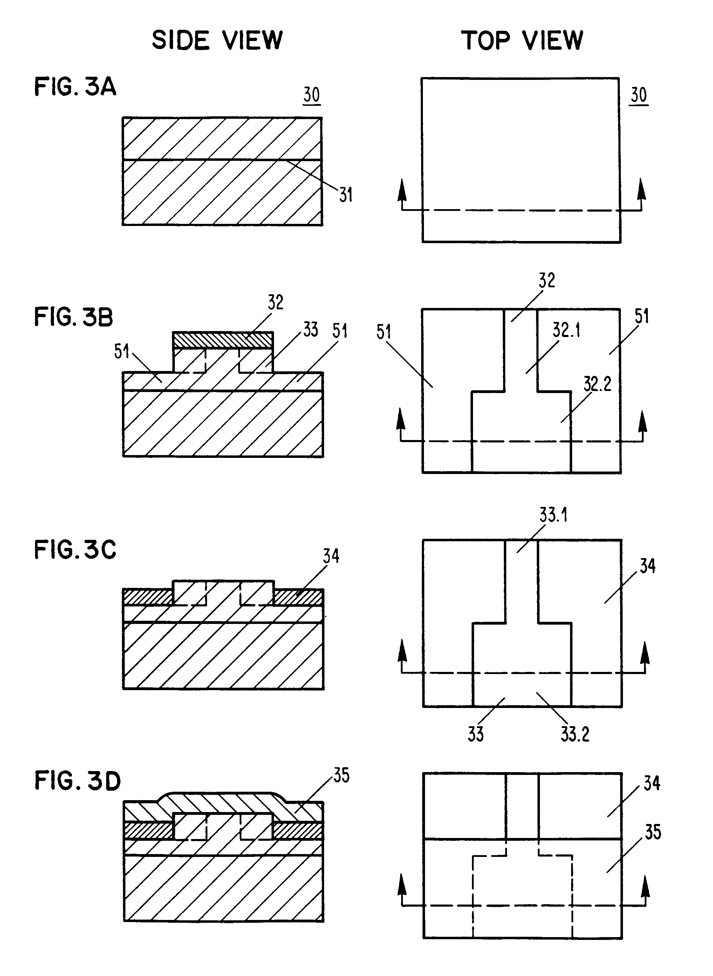

In Fig. 3A to 3G, the successive steps of the inventive method, applied to produce a ridge SQW GRINSCH laser, are illustrated in detail. Each figure includes two drawings, showing a cross-sectional view (left) and a top view (right) of the processed structure, respectively.

In the specific embodiment described with the aid of these figures, the laser structure consists of a stack of AlGaAs/GaAs layers grown on the (100) surface of an n-type GaAs wafer using a molecular beam epitaxy (MBE) process. The mirror facets are provided by the vertical walls of a groove etched into the stack.

As illustrated in Fig. 3A, the process is initiated starting from the layered AlGaAs/GaAs laser structure 30 , degreased and cleaned, ready for the process steps required for ridge and mirror facet fabrication. For simplicity and clarity reasons, of all the layers in the stack only the active layer 31 is individually shown.

First, a positive resist is applied, exposed with the laser ridge pattern and developed (using contact lithography and a Cr mask). The patterned photoresist 32, with a (usually long) narrow section 32.1 and a widened section 32.2, then serves as a mask in a wet etch step (in a solution of H₂SO₄/H₂O₂/H₂O) to form the ridge 33 having the same shape as the photoresist. The etched surface areas are designated 51 (Fig. 3B).

Typical dimensions for a single-mode waveguide are a ridge height of 1.5 µm, a ridge width of 3 µm, and a ridge (or laser cavity) length of 200 to 1000 µm. The widened waveguide end section has to be at least 8 µm wide and should, after mirror etching, be about 2 µm long.

Subsequently, a Si₃N₄ insulation layer 34 of 200 nm thickness is deposited, using a plasma enhanced chemical vapor deposition (PECVD) process, thereby embedding both, the ridge 33 and the photoresist mask 32. The resist is then lifted-off (in Acetone) leaving a self-aligned unisolated contact stripe on top of the ridge 33 whereas the etched areas 51 remain covered by the insulation layer 34 (Fig. 3C).

Next, a polyimide layer is deposited and structured [using a reactive ion etch (RIE) process with O₂] to serve as a lift-off mask 35 for the definition of the top (p-) contact pad of the laser. The mask ends about 2 µm from the widened ridge end section 33.2 as shown in Fig. 3D.

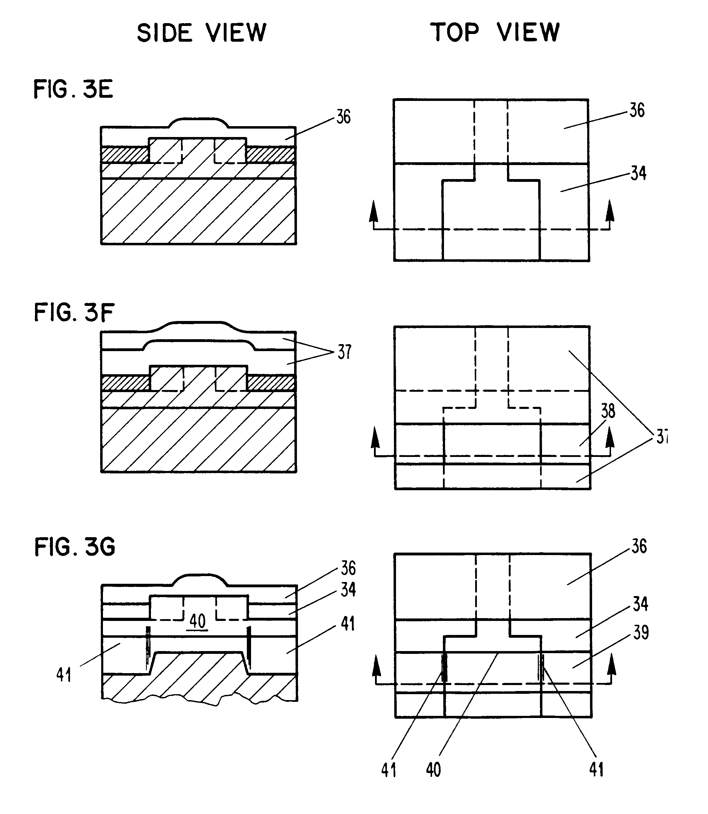

Then, a TiPtAu film is deposited, followed by lift-off resulting in the top contact 36 extending over the length of the ridge but ending about 2 µm in front of the widened ridge end section, thereby leaving a window for the etching of the mirror groove (Fig. 3E).

In a next step, or sequence of steps, a mask 37 for etching the mirror groove is formed. A single layer mask may be used but a multi-layer structure is preferred because it provides for smoother vertical mirror facets. Such multi-layer etch mask and its use in the fabrication of opto-electronic semiconductor structures is described in European Patent application 88.810.613.5 (filed on September 12, 1988. It consists of two photoresist layers, a hard-baked bottom layer and a soft-baked top layer, with a thin amorphous dielectric intermediate layer sandwiched inbetween. The etch pattern, lithographically formed in the top resist layer, is successively transferred, first into the intermediate layer and then into the bottom hard-baked resist layer, the latter serving as actual mask 37 during the subsequent mirror groove etch process. It is patterned to expose the underlaying semiconductor structure area 38 (Fig. 3F).

For mirror groove etching, a Cl₂/Ar - CAIBE process is used with an Argon energy of 500 eV and a Cl₂ flow of 15 sccm through a feed ring, the sample rotating at room temperature for 15 minutes. After etching, the hard-baked resist 37 is removed by ashing in an O₂ plasma. This is followed by cleaning in solvents (Fig. 3G).

The resulting mirror groove 39, providing the mirror facet 40, has a depth of 4 to 6 µm and the facets have a roughness of less than 20 nm. Facet curvature is only found under the edges (41) of the widened ridge end sections, whereas the light mode region is confined to the absolutely flat region of the mirror.

Fig. 3 illustrates the fabrication of only one of the mirror facets of a laser diode. The facet at the other end of the waveguide can, at the same time, be produced. Low and high reflectivity coatings can then be deposited on these front and rear facets by angled ion beam sputtering. The simplest process consists of applying an Al₂O₃ passivation layer on each facet. Via holes are then etched through the coating to get access to the bonding pads using a simple resist mask and a CF₄ - RIE step.

To simplify chip cleavage, the substrate is either lapped or wet etched on the backside (bottom surface of the structure) to a thickness of 150 µm. After Ar sputter cleaning, a GeAuNiAu metallization is evaporated and alloyed at 390 degree C for 60 seconds to form the bottom (n-) contact.

The invention has been described in detail as applied to the fabrication of a ridge diode laser, more specifically, a ridge SQW GRINSCH laser. It should, however, be understood that the invention is also applicable to other integrated optic structures with non-planar stripe waveguides such as groove diode lasers (with negative topography) or passive waveguides and devices such as modulators and switches.

It is also noted that the sequence of the process steps may be modified. In the above described embodiment, the stripe waveguide, having a widened end section, was formed before mirror facet etching. This sequence may be changed by first etching the groove forming mirror facets into the initial layer structure, and then forming the stripe waveguide with the widened end section. The common feature which is key to the inventive method is that, during etching of (1) the mirror facet (if the waveguide is formed before), or (2) the waveguide structure (if the mirror facet is etched before), the mirror facet in the light mode region is "protected" by the widened end section of the waveguide.

Furthermore, other materials may be used and various other modifications made. In general, the process parameters, etchants or plasma used, the indicated dimensions and other device characteristics chosen for the description of the preferred embodiment, may be changed without departing from the scope of the invention.

## Claims

1. A method for improving the flatness of etched mirror facets of an integrated optic structure with a non-planar stripe waveguide (17),
the method comprising the steps of
- forming said structure (22) on a wafer, the stripe waveguide (17) having at least one widened end section (23), and
- anisotropic mirror facet etching, the facet plane (18) crossing the widened end section (23) of the waveguide such that only a short part thereof remains, so as to minimize the length of the non-guiding widened section.

2. A method for improving the flatness of etched mirror facets of an integrated optic structure with a non-planar stripe waveguide,
the method comprising the steps of
- growing, on a wafer, a stack of layers from which said structure is to be formed,
- anisotropic etching of a mirror groove to form said mirror facet, and
- etching said stripe waveguide, the waveguide having at least one short widened end section contiguous to the etched mirror facet, the end section being substantially wider than the lateral extension of the full-width-at-half-maximum (FWHM) of the light mode intensity distribution.

3. A method for improving the flatness of etched mirror facets as in claim 1, wherein said structure is a ridge diode laser (22) formed in a stack of III-V compound semiconductor layers, the stack comprising at least an active layer (13) and surrounding upper and lower cladding layers (12, 14) providing for the light mode region (24) of the laser,
and wherein the method comprises the steps of
- providing a semiconductor substrate (11) on which said stack of layers is formed into which a waveguiding ridge structure (17) and a groove, the sidewalls of the latter serving as mirror facets, are to be etched,
- etching said upper cladding layer (14) to form a ridge (17) having a long narrow center waveguide section and, at least at one end thereof, a widened end section (23), the latter being substantially wider than the lateral extension of the full-width-at-half-maximum (FWHM) of said light mode (24) intensity distribution, and
- applying an anisotropic dry etch process to etch through said widened end section (23) of the ridge and into said stack of layers to form said groove such that it is
a) deep enough to pass through said active layer (13) and said cladding layers (12,14), and
b) placed such that only a short part of the widened section of the ridge remains so as to minimize the length of the non-guiding widened section,
whereby the resulting facet curvature (29), which is due to topographic, lithographic and/or etching effects, occurs at the edges of the widened end section (23) of the ridge and not in the light mode region (24).

4. A method for improving the flatness of etched mirror facets as in claim 1 or 3, wherein said widened end section (23) is substantially wider (w) than the lateral extension of the full-width-at-half-maximum (FWHM) of the light mode (24) intensity distribution.

5. A method for improving the flatness of etched mirror facets as in claim 1, 2 or 3, wherein said widened end section (23) has a width (w) of at least 8 µm.

6. A method for improving the flatness of etched mirror facets as in claim 1, 2 or 3, wherein said widened end section (23) has a length (l) of between 1 and 5 µm.

7. A method for improving the flatness of etched mirror facets as in claim 1, 2 or 3, wherein, for said anisotropic etching, a chemically assisted ion beam etch (CAIBE) process is used.

8. An integrated optic device (22) with a non-planar stripe waveguide (17) having, at least at one end thereof, an etched mirror facet (40), wherein
said non-planar stripe waveguide (17) consists of a long narrow waveguide section, characterized in that at its end next to the etched mirror facet, the long narrow section has a short widened end section (23), the latter being substantially wider than the lateral extension of the full-width-at-half-maximum (FWHM) of the light mode section (24) intensity distribution of the device.

9. An integrated optic device as in claim 8, wherein said device is a ridge diode laser (22) comprising an active layer (13) and surrounding cladding layers (12, 14) in which, in operation, the light mode region (24) is formed.

10. An integrated optic device as in claim 8 or 9, wherein said widened end section (23) has a width (w) of at least 8 µm.

11. An integrated optic device as in claim 8 or 9, wherein said widened end section (23) has a length (l) of between 1 and 5 µm.

## Patentansprüche

1. Ein Verfahren zur Verbesserung der Ebenheit von geätzten Spiegelfacetten einer integrierten optischen Struktur mit einem nicht planaren Streifen-Wellenleiter (17),
das Verfahren umfaßt die folgenden Schritte
- Bildung der Struktur (22) auf einem Waver, wobei der Streifen-Wellenleiter (17) wenigstens einen verbreitete Endabschnitt (23) aufweist und
- anisotropes Ätzen der Spiegelfacetten, wobei die Facettenebene (18) den verbreitete Endabschnitt (23) auf dem Weltenleiter derart kreuzt, daß nur ein kleiner Teil davon bestehen bleibt, um so die Länge des nicht leitenden, verbreitete Abschnittes auf ein Minimum zu reduzieren.

2. Ein Verfahren zur verbesserung der Ebenheit von geätzten Spiegelfacetten auf einer integrierten optischen Struktur mit einem nicht planaren Streifen-Weltenleiter,
das Verfahren umfaßt die folgenden Schritte
- Aufwachsen eines Stapels von Lagen auf einem Wafer, aus denen die besagte Struktur gebildet werden muß,
- anisotropes Ätzen einer Aussparung im Spiegel, um die besagte Spiegelfacette zu bilden und
- Ätzen des Streifen-Wellenleiters, wobei der Weltenleiter wenigstens einen kurzen verbreitete Endabschnitt, angrenzend an die geätzte Spiegelfacette, aufweist, und der Endabschnitt wesentlich breiter ist als die seitliche Ausdehnung der vollen-Breite-bei-halbem-Maximum (FWHM) der Intensitätsverteilung der Lichtwellen.

3. Ein Verfahren zur Verbesserung der Ebenheit von geätzten Spiegelfacetten, gemäß Anspruch 1, wobei besagte Struktur eine Steglaserdiode (22) ist, die in einem Stapel von III bis V Halbleiter-Verbundlagen gebildet ist, und der Stapel wenigstens eine aktive Lage (13) enthält und von oberen und unteren beschichteten Lagen (12,14) umgeben ist, die für den Lichtwellenbereich (24) des Lasers vorgesehen sind,
und wobei das Verfahren folgende Schritte umfaßt
- Schaffung eines Halbleitersubstrats (11), auf dem besagter Stapel von Lagen gebildet wird, auf welche eine Stegwellenleiter-Struktur (17) und eine Aussparung geätzt werden müssen, die Seitenwände der letzteren dienen als Spiegelfacetten,
- Ätzen der oberen beschichteten Lage (14) zum Bilden eines Steges (17), der einen langen, schmalen, zentralen Wellenleiterbereich enthält, und, wenigstens am einen Ende davon, einen ausgedehnten Endabschnitt (23), wobei letzterer wesentlich breiter ist als die seitliche Ausdehnung der vollen-Breite-bei-halbem-Maximum (FWHM) der Intensitätsverteilung der Lichtwellen, und
- die Anwendung eines anisotropen Trockenätzverfahrens zum Durchätzen des erweiterten Endabschnittes (23) des Steges und in den besagten Stapel von Lagen, um die Aussparung zu bilden, so daß sie
a) tief genug ist, um durch die aktive Schicht (13) und die Plattierschichten (12, 14) zu reichen, und
b) so angeordnet ist, daß nur ein kurzer Teil des verbreiterten Abschnittes des Steges stehen bleibt, und so die Länge des nichtleitenden, verbreiterten Abschnittes auf ein Minimum zu bringen,
wobei die entstehende Facettenkrümmung (29), die von topographischen, lithographischen und/oder Auswirkungen beim Ätzen abhängt, an den Rändern des verbreitete Endabschnittes (23) des Steges und nicht im Lichtwellenbereich (24) eintritt.

4. Ein Verfahren zur Verbesserung der Ebenheit geätzter Spiegelfacetten, wie in Anspruch 1 oder 3, wobei der verbreitete Endabschnitt (23) wesentlich weiter (w) ist, als die seitliche Ausdehnung der vollen-Breite-bei-halbem-Maximum (FWHM) der Intensitätsverteilung der Lichtwellen (24).

5. Ein Verfahren zur Verbesserung der Ebenheit geätzter Spiegelfacetten, wie in Anspruch 1, 2 oder 3, wobei der erweiterte Endabschnitt (23) eine Weite (w) von wenigstens 8 µm hat.

6. Ein Verfahren zur Verbesserung der Ebenheit geätzter Spiegelfacetten, wie in Anspruch 1, 2 oder 3, wobei der erweiterte Endabschnitt eine Länge (l) von zwischen 1 und 5 µm hat.

7. Ein Verfahren zur Verbesserung der Ebenheit geätzter Spiegelfacetten, wie in Anspruch 1, 2 oder 3, wobei zum anisoptropen Ätzen ein chemisch unterstütztes Plasmaätzverfahren (CAIBE) verwendet wird.

8. Eine integrierte optische Vorrichtung (22) mit einem nicht planaren Streifen-Wellenleiter (17), der an wenigstens einem Ende eine geätzte Spiegelfacette (40) aufweist, wobei der nicht planare Streifen-Wellenleiter (17) aus einem langen, schmalen Wellenleiterabschnitt besteht, dadurch gekennzeichnet, daß an seinem Ende neben der geätzten Spiegelfacette der lange, schmale Abschnitt einen kurzen, verbreitete Endabschnitt (23) hat, wobei letzterer wesentlich breiter ist als die seitliche Ausdehnung der-vollen-Breitebei-halbem-Maximum (FWHM) der Intensitätsverteilung des Lichtwellenabschnitts (24) des Gerätes.

9. Eine integrierte optische Vorrichtung, wie in Anspruch 8, wobei die Vorrichtung eine Steglaserdiode (22) ist, die aus einer aktiven Lage (13) und den umgebenden beschichteten Lagen (12, 14) besteht, worin im Betriebszustand der Lichtwellenbereich (24) gebildet wird.

10. Eine integrierte optische Vorrichtung, wie in Anspruch 8 oder 9, wobei der verbreitete Endabschnitt (23) eine Weite (w) von wenigstens 8 µm hat.

11. Eine integrierte optische Vorrichtung, wie in Anspruch 8 oder 9, wobei der verbreitete Endabschnitt (23) eine Länge (l) von zwischen 1 und 5 µm hat.

## Revendications

1. Méthode pour améliorer la planéité des facettes de miroir gravées d'une structure optique intégrée à guide d'ondes en bande non plan,
la méthode comprenant les étapes de:
- former ladite structure sur une tranche, le guide d'ondes (17) en bande ayant au moins une section terminale élargie (23), et
- graver une facette de miroir anisotropique, le plan de la facette traversant la section terminale élargie (23) du guide d'ondes de façon à garder seulemnt une partie de celui-ci, de manière à minimiser la longueur de la section élargie qui ne fait pas guide d'ondes.

2. Méthode pour améliorer la planéité des facettes de miroir gravées d'une structure optique intégrée à guide d'ondes en bande non plan,
la méthode comprenant les étapes de:
- monter, sur une tranche, une pile de couches à partir de laquelle ladite structure doit être formée,
- graver de façon anisotropique une cavité miroir pour former ladite facette de miroir, et
- graver ledit guide d'ondes en bande, le guide d'ondes ayant au moins une courte section terminale élargie contiguë à la facette de miroir gravée, la section terminale étant substantiellement plus large que l'extension latérale de la largeur-entière-à-la-moitié-du-maximum (FWHM) de la distribution d'intensité en mode lumière.

3. Méthode pour améliorer la planéité des facettes de miroir gravées telle que revendiquée dans la revendication 1, dans laquelle ladite structure est un laser diode à arête (22) formé dans une pile de couches de semiconducteurs de composés III-IV, la pile comprenant au moins une couche active (13) et des couches de recouvrement supérieure et inférieure (12, 14) fournissant la région de mode lumière (24) du laser,
et dans laquelle la méthode comprend les étapes de:
- fournir un substrat semiconducteur (11) sur lequel ladite pile de couches est formée où doivent être gravées une structure d'arête guide d'ondes (17) et une gorge dont les bords servent de facettes de miroir,
- graver ladite couche de recouvrement supérieure (14) pour former une arête (17) ayant une section de guide d'ondes de centre longue et étroite et, au moins à une des extrémités, une section terminale élargie (23), celle-ci étant substantiellement plus large que l'extension latérale de la largeur-entière-à-la-moitié-du-maximum (FWHM) de ladite distribution d'intensité en mode lumière (24), et
- appliquer un procédé de gravure anisotropique à sec pour graver à travers ladite section terminale élargie (23) de l'arête et dans ladite pile de couches pour former ladite cavité de telle sorte qu'elle soit
a) assez profonde pour passer à travers ladite couche active (13) et lesdites couches de recouvrement (12,14) et
b) placée de manière à ce que seulement une petite partie de la section élargie de l'arête subsiste de façon à minimiser la longueur de la section ,élargie qui n'est pas guide d'ondes,
de sorte que la courbure (29) de facette qui en résulte, qui est due aux effets topographiques, lithographiques et/ou de gravure, se trouve aux extrémités de la section terminale élargie (23) de l'arête et non dans la région en mode lumière (24).

4. Méthode pour améliorer la planéité des facettes de miroir gravées selon la revendication 1 ou 3, dans laquelle ladite section terminale élargie (23) est substantiellement plus large (W) que l'extension latérale de la largeur-entière-à-la-moitié-du-maximum (FWHM) de la distribution d'intensité en mode liumière.

5. Méthode pour améliorer la planéité des facettes de miroir gravées selon la revendication 1, 2 ou 3, dans laquelle ladite section terminale élargie (23) a une largeur (W) d'au moins 8 µm.

6. Méthode pour amélioreer la planéité des facettes de miroir gravées selon la revendication 1, 2 ou 3, dans laquelle ladite section terminale élargie (23) a une longueur comprise entre 1 et 5 µm.

7. Méthode pour améliorer la planéité des facettes de miroir gravées selon la revendication 1, 2 ou 3, dans laquelle, pour ladite gravure anisotropique, un procédé de gravure par faisceau d'ions assisté chimiquement (CAIBE) est utilisé.

8. Dispositif optique intégré (22) avec un guide d'ondes (17) en bande non plan ayant, à au moins une de ses extrémités, une facette de miroir gravée (40), dans lequel ledit guide d'ondes non plan (17) consiste en une section de guide d'ondes longue et étroite, caractérisé en ce qu'à son extrémité proche de la facette de miroir gravée, la section longue et étroite a une courte section terminale élargie (23), cette dernière étant substantiellement plus large que l'extension latérale de la largeur-entière-à-la-moitié-du-maximum (FWHM) de la distribution d'intensité de la section en mode lumière (24) du dispositif.

9. Dispositif optique intégré selon la revendication 8, dans lequel ledit dispositif est un laser diode à erête (22) comprenant une couche active (13) et des couches de recouvrement (12, 14) dans lesquelles, en fonctionnement, est formée la région (24) en mode lumière.

10. Dispositif optique intégré selon la revendication 8 ou 9, dans lequel ladite section terminale élargie (23) a une largeur (W) d'au moins 8 µm.

11. Dispositif optique intégré selon la revendicatiobn 8 ou 9, dans lequel ladite section terminale élargie (23) a une largeur (l) comprise entre 1 et 5 µm.
